# EUROPEAN PATENT APPLICATION

(11) **EP 4 819 491 A2**
(43) Date of publication of application: **07.10.2026**
(21) Application number: 26162989.3
(22) Date of filing: 06.03.2026
(51) Int. Cl.: H03H 11/42, G06N 10/40, H01P 1/397

(54) **CIRCULATORS WITH VOLTAGE-TUNABLE INDUCTORS FORMED USING SUPERCONDUCTOR-SEMICONDUCTOR JUNCTIONS**

(30) Priority: 04.04.2025 US 202563783428 P; 04.06.2025 US 202519228365
(71) Applicant: Microsoft Technology Licensing LLC, Redmond, WA 98052-6399 (US)
(72) Inventor: CHAPMAN, Benjamin J., Redmond, 98052-6399 (US); LUTCHYN, Roman Mykolayovych, Redmond, 98052-6399 (US); MANFRA, Michael James, Redmond, 98052-6399 (US); JOSHI, Vidul Ravindra, Redmond, 98052-6399 (US); OHKI, Thomas, Redmond, 98052-6399 (US); PAUKA, Sebastian, Redmond, 98052-6399 (US); REILLY, David, Redmond, 98052-6399 (US)
(74) Representative: Page White Farrer

(57) **Abstract**

Circulators with voltage-tunable inductors formed using superconductor-semiconductor junctions are described. An example circulator includes a first transfer switch (220) including a first plurality of ports, where the first transfer switch comprises a first plurality of superconductor-semiconductor junctions. The circulator further comprises a second transfer switch (240) including a third plurality of ports, where the second transfer switch comprises a second plurality of superconductor-semiconductor junctions. The circulator further comprises a first delay line (212) and a second delay line (214) coupled between the first transfer switch and the second transfer switch. Modulation of gate voltages being applied to respective superconductor-semiconductor junctions allows the first transfer switch and the second transfer switch, in combination with the first delay line and the second delay line, to enable non-reciprocal communication with the quantum device.

## Description

### BACKGROUND

Integrating readout subsystems with quantum systems requires the isolation of noise from the qubit plane. Noise from the environment or classical control and readout systems degrades qubit performance. One of the ways to mitigate this inevitable source of decoherence is to use the unique properties of non-reciprocal devices to reduce noise ingress to the qubit while allowing quantum information egress to the classical readout system. Non-reciprocity also enables control and routing within a quantum processor.

Non-reciprocal devices rely on specialized properties that enable breaking of time-reversal symmetry. Typically, these specialized devices such as RF and microwave isolators and circulators are implemented with bulky ferrite materials, making them difficult to miniaturize, as they are typically constructed without superconductors. They are also challenging to realize with wideband response. Moreover, under certain operating conditions, such as high magnetic fields, their performance can degrade. Other devices based on Josephson junctions, opto-mechanical systems, Hall effect, and semiconductor conductivity modulation have been proposed to mitigate some of these problems. However, none of these classes of devices have been able to sufficiently address all of the issues surrounding the use of non-reciprocal devices, such as circulators, within quantum systems.

Accordingly, there is a need for improvements to non-reciprocal devices, such as circulators, for use with quantum systems.

### SUMMARY

In one example, the present disclosure relates to a circulator for enabling non-reciprocal communication with a quantum device. The circulator may comprise a first transfer switch including a first plurality of ports, where the first transfer switch comprises a first plurality of superconductor-semiconductor junctions. The circulator may further comprise a second transfer switch having a second plurality of ports, where the second transfer switch comprises a second plurality of superconductor-semiconductor junctions.

The circulator may further comprise a first delay line coupled between the first transfer switch and the second transfer switch. The circulator may further comprise a second delay line coupled between the first transfer switch and the second transfer switch. Modulation of gate voltages being applied to respective superconductor-semiconductor junctions allows the first transfer switch and the second transfer switch, in combination with the first delay line and the second delay line, to enable non-reciprocal communication with the quantum device.

In another example, the present disclosure relates to a method for enabling readout of a quantum device. The method may include providing a first transfer switch including a first plurality of ports, where the first transfer switch comprises voltage-tunable inductors including a first plurality of superconductor-semiconductor junctions. The method may further include providing a second transfer switch including a second plurality of ports, where the second transfer switch comprises voltage-tunable inductors including a second plurality of superconductor-semiconductor junctions.

The method may further include providing a first delay line coupled between the first transfer switch and the second transfer switch. The method may further include providing a second delay line coupled between the first transfer switch and the second transfer switch. The method may further include enabling non-reciprocal communication with the quantum device by tuning the voltage-tunable inductors responsive to modulation of gate voltages being applied to respective superconductor-semiconductor junctions.

In yet another example, the present disclosure relates to a qubit readout system coupled to a quantum device. The qubit readout system may comprise a readout path including a circulator for enabling non-reciprocal communication with the quantum device.

The circulator may comprise a first active transfer switch and a second active transfer switch. The circulator may further comprise a second plurality of delay lines coupled to a second active transfer switch. The circulator may further comprise a pair of delay lines coupled to both the first active transfer switch and the second active transfer switch, where each of the first active transfer switch and the second active transfer switch includes voltage-tunable inductors comprising superconductor-semiconductor junctions.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

### BRIEF DESCRIPTION OF THE DRAWINGS

The present disclosure is illustrated by way of example and is not limited by the accompanying figures, in which like references indicate similar elements. Elements in the figures are illustrated for simplicity and clarity and have not necessarily been drawn to scale.
FIG. 1 shows an example system in which circulators described herein can be deployed;
FIG. 2 shows an example circulator with active transfer switches and delay lines;
FIG. 3 shows a schematic of an example superconductor-semiconductor junction;
FIG. 4 shows a cross-section view of a hybrid superconductor-semiconductor device including a superconductor-semiconductor junction for use with any of the active transfer switches of FIG. 2;
FIG. 5 is a diagram illustrating the operation of a circulator in response to the gate voltage in accordance with one example;
FIG. 6 is a block diagram of another example system including a circulator in accordance with one example; and
FIG. 7 shows a flow chart of a method for enabling readout of a quantum device in accordance with one example.

### DETAILED DESCRIPTION

Circulators are critical components for achieving high-fidelity qubit readout and typically have been implemented with ferrites. Traditional ferrite-based circulators are bulky, lossy, sensitive to external fields and are not scalable. Various implementations of circulators have been proposed that provide a size reduction to the conventional ferrite designs. Ultra-low-power Josephson junctions (JJs) based active non-reciprocal devices, such as narrow band parametric circulators and wideband switched circulators (also based on conventional JJs), have recently been demonstrated. As previously mentioned, there are certain drawbacks to using only conventional Josephson junctions or CMOS implementations. While superconducting Josephson junction-based circulators have resulted in an improved performance, they still require improvements.

Examples described herein relate to circulators with voltage-tunable inductors formed using superconductor-semiconductor junctions. The approach described herein relies on two aspects of the hybrid superconductor-semiconductor devices. The first aspect relates to providing a hybridization of effects that rely on the inductive properties of the Josephson effect. The second aspect relates to the voltage tuning of the semiconducting material to implement a switched isolator based on the superconductor-semiconductor junctions. Various types of stacks of materials can be used to form superconductor-semiconductor junctions within such devices. In one example, to achieve larger gaps one can use superconducting lead (Pb) to form high spin-orbit coupled InSb and InSbAs semiconductors. Larger gaps result in large critical current, which in turn allows one to achieve a larger dynamic range than achievable with the conventional material stacks.

The examples described herein realize active elements (voltage-tunable inductors) with the superconductor-semiconductor junctions to provide a voltage tunable inductance modulation. In this way, one can preserve the voltage gating modulation of the device that reduces complexity and provides resilience against flux noise and inductive crosstalk, both of which are native to the conventional superconducting quantum interference device (SQUID)-based circuits. In addition, advantageously one can achieve a reduction in the footprint by replacing the SQUIDs with the superconductor-semiconductor junctions while not incurring the power dissipation penalty or the insertion loss of semiconducting-transistors. A significant challenge for this device's implementation is designing fast, low-loss, broadband switches and low-loss dispersion-free delays. This requires careful RF design and simulation, especially with respect to isolating signal and control lines. The modular nature of the switches and delay lines described herein allows one to design and test switches and delays individually.

To preserve the broad bandwidth possible with this design while at the same time reducing the device footprint, some of the examples described herein miniaturize the delay lines using high kinetic inductance superconducting thin films. Advantageously, the group velocity in such metamaterial transmission lines can be reduced by an order of magnitude relative to transmission lines which utilize only geometric inductances. When constructed with the superconductor-semiconductor junctions, such a design has the potential to completely replace ferrite-based circulators. This is because the anticipated performance of such designs in terms of insertion loss, bandwidth, and isolation exceeds the performance of commercial ferrite devices. Additional advantages relate to a smaller footprint and compatibility with large magnetic fields, while still providing enough power-handling to be used simultaneously on dozens of readout channels.

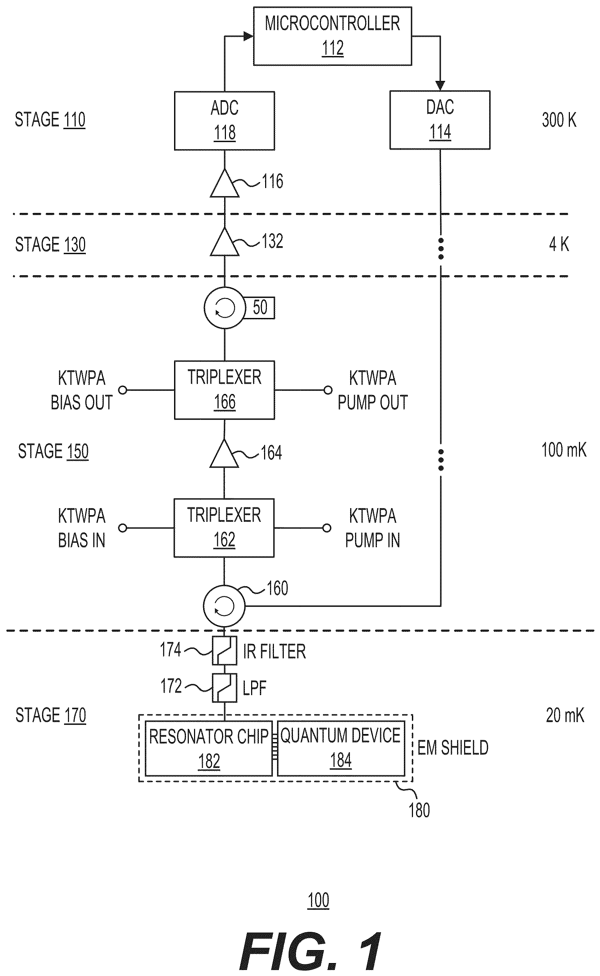

FIG. 1 shows an example system 100 in which circulators described herein can be deployed. In this example, system 100 includes multiple stages, each of which may be configured to operate in different temperature environments. As an example, system 100 includes stages 110, 130, 150, and 170. Stage 110 may include components configured to operate at the ambient temperature) (e.g., between 77 kelvin to 300 kelvin). Stage 130 may include components configured to operate at or below 77 kelvin and up to 4 kelvin. Stage 150 may include components configured to operate at or below 100 milli-Kelvin (mK). Stage 170 may include components configured to operate at or below 20 milli-Kelvin (mK). One or more dilution refrigerators, not shown, may be used to maintain temperatures at or below 100 mK. In addition, some of the components may be located in a housing (not shown) that maintains a vacuum. A microcontroller 112 may generate control signals configured to control qubits and other aspects of system 100. A digital to analog converter (DAC) 114 receives digital control signals from microcontroller 112 (or from other components) and converts those into an analog form. The analog signals are then transmitted to the other stages. An analog to digital converter (ADC) 118 receives analog signals from stage 130 via a low noise amplifier (LNA) 116. ADC 118 converts the analog signals received from LNA 116 and provide those to microcontroller 112.

With continued reference to FIG. 1, stage 130 includes components configured to interconnect stage 110 with stage 150 in a manner that reduces thermal load and allows efficient connectivity between the components at room temperature and the components at 100 milli-Kelvin (mK). Stage 130 can include several cables comprising conductors implemented using niobium and copper or other similar materials. Stage 130 further includes a high-electron-mobility transistor (HEMT) 132 for receiving analog signals from stage 150 and providing those to stage 110. Stage 150 includes a path for carrying analog signals from DAC 114 to circulator 160. Stage 150 further includes a second path for communicating signals output by circulator 160 to stage 130. The second path includes a triplexer 162 coupled via an amplifier 164 to another triplexer 166. The second path further includes other components for interfacing with stage 130. Triplexer 162 receives the output from circulator 160 and provides output to amplifier 164. Triplexer 162 further receives a bias signal via the kinetic inductance traveling wave parametric amplifier (KTWPA) BIAS IN terminal and a pump signal via the KTWPA PUMP IN terminal. The pump signal may provide the power used to amplify the input signal. Triplexer 166 receives the output from amplifier 164 and provides an output for coupling with stage 130. Triplexer 166 further outputs a bias signal via the KTWPA BIAS OUT terminal and a pump signal via the KTWPA PUMP OUT terminal.

Still referring to FIG. 1, stage 170 includes a quantum system 180, which includes an electromagnetic (EM) shield that encloses a resonator chip 182 and a quantum device 184. Quantum system 180 may be coupled to circulator 160 via a low pass filter (LPF) 172 and an infrared (IR) filter 174. Resonator chip 182 may contain multiple inductive, capacitive, and resistive elements of suitable sizes to form bank(s) of resonators. At cryogenic temperatures, resonator circuits exhibit superconductivity and produce a resonator with high quality factors. This may provide an efficient low loss frequency multiplexing mechanism. Hybrid superconductor-semiconductor devices are examples of quantum devices that can be used as part of quantum systems, such as quantum system 180. Some of the quantum devices may comprise a 2-dimensional gas (2DEG), which may be manufactured by forming a series of layers of semiconductors on a substrate (e.g., using any of indium phosphide (InP), indium arsenide (InAs), indium antimonide (InSb), mercury cadmium telluride (HgCdTe), or any appropriate combination of materials selected from groups II, III, IV, V, or VI of the periodic table, or any ternary compounds of three different atoms of materials selected from groups II, III, IV, V, or VI of the periodic table). Other quantum devices may include nanowires or networks of nanowires. Additional quantum devices may include topological quantum devices with quantum dots, chains of quantum dots, and regions for inducing Majorana zero modes. Although FIG. 1 shows the system 100 as having a certain number of components and interconnects that are arranged in a certain manner, system 100 may include additional or fewer components and interconnects arranged differently. As an example, quantum system 180 may not include a resonator chip 182. Instead, the quantum device 184 may include components that provide similar functionality.

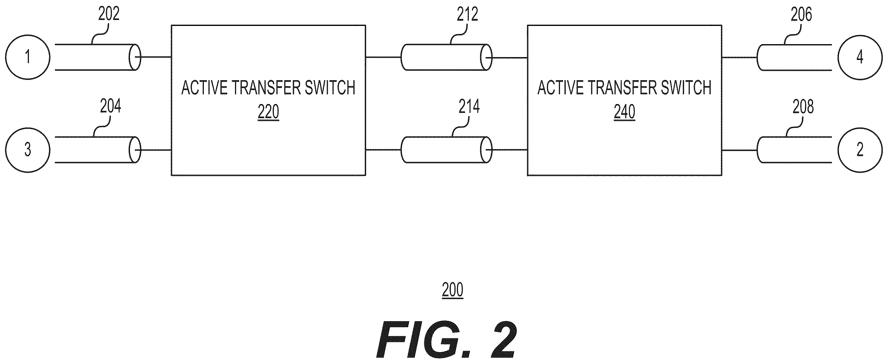

FIG. 2 shows an example circulator 200 with active transfer switches and delay lines. Circulator 200 includes two delay lines 212 and 214 that are arranged as shown in FIG. 2. Circulator 200 further includes two active transfer switches 220 and 240, which are arranged as shown in FIG. 2. Circulator 200 includes port 1 202, port 2 208, port 3 202, and port 4 206. Delay lines 212 and 214 are coupled to both active transfer switches 220 and 240. Each of the active transfer switches 220 and 240 includes voltage-tunable inductors comprising superconductor-semiconductor junctions. The active transfer switches 220 and 240 can be actuated by applying gate voltages to the superconductor-semiconductor junctions. As used herein the term "active transfer switch" refers to any switch that does not use passive devices, such as ferrite devices. To realize circulation using these switches, active transfer switches 220 and 240 are activated with a 90 degrees phase difference, and with a period that is four times the duration of the delay provided by delay lines 212 and 214. In terms of the operation of the switches, time-domain active switching is implemented by turning on and off the active transfer switches 220 and 240 to ensure that signals (e.g., microwave signals) always travel in one particular direction. In one example, each of the active transfer switches 220 and 240 is configured to operate in one of two configurations: a cross-configuration or a through-configuration. In the cross-configuration, signals cross over from a first side (e.g., the top side) of the active transfer switch to the other side (e.g., the bottom side) of the same active transfer switch. In the through-configuration, signals go through from a first side (e.g., the top side) of the active transfer switch to the same side (e.g., the top side) of the same active transfer switch. By toggling the active transfer switches 220 and 240 between the two configurations, as time progresses, one can achieve the desired operation of the circulator.

Each of delay lines 212 and 214 may be implemented as metamaterial transmission lines (MTLs). Each of the MTLs may be formed by using superconducting thin films, including any superconductor (e.g., Niobium), any normal metal (e.g., copper or aluminum), or any appropriate combination of such metals. To preserve the broadest bandwidth possible with this design while at the same time reducing the device footprint, the approach described herein miniaturizes the delay lines with high kinetic inductance superconducting thin films. As noted earlier, the group velocity in such metamaterial transmission lines can be reduced by an order of magnitude relative to transmission lines which utilize only geometric inductances. Although FIG. 2 shows circulator 200 as having a certain number of components that are arranged in a certain manner, circulator 200 may include addition or fewer components, arranged differently.

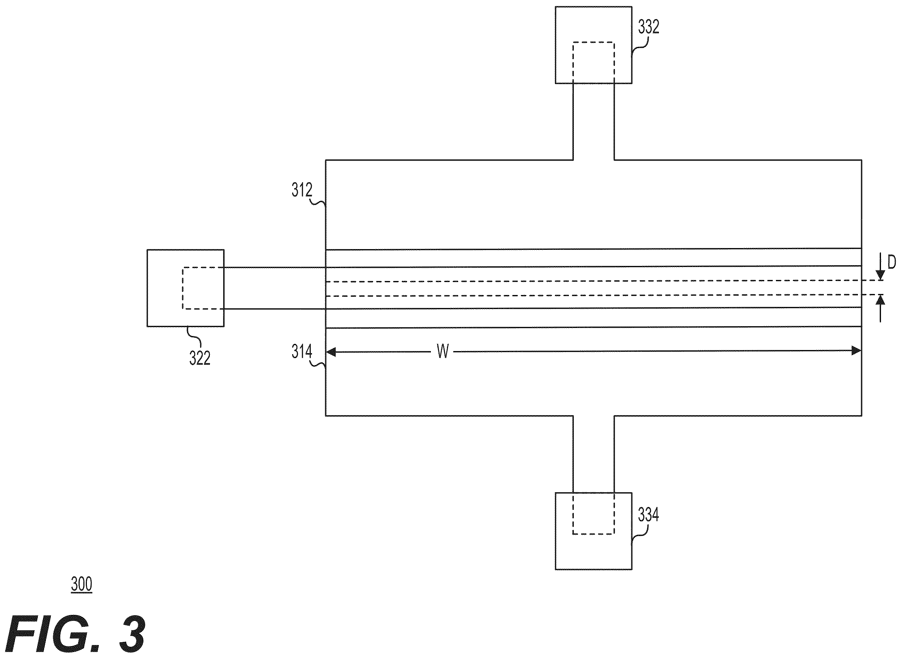

FIG. 3 shows a schematic of an example superconductor-semiconductor junction 300, which can be included as part of any of the active transfer switches described earlier. Superconductor-semiconductor junction 300 is formed in a 2-dimensional gas (2DEG) 312 with a superconductor 314 shown as overlying 2DEG 312. The 2DEG may be manufactured by forming a series of layers of semiconductors on a substrate (e.g., using any of indium phosphide (InP), indium arsenide (InAs), indium antimonide (InSb), mercury cadmium telluride (HgCdTe), or any appropriate combination of materials selected from groups II, III, IV, V, or VI of the periodic table, or any ternary compounds of three different atoms of materials selected from groups II, III, IV, V, or VI of the periodic table). Superconductor-semiconductor junction 300 can be formed using a three-terminal device, including a gate terminal 322, a terminal 332, and another terminal 334 (terminals 332 and 334 act as the two ends of the voltage-tunable inductor). Voltage applied via gate terminal 322 can be used to control the tunable inductance associated with the superconductor-semiconductor junction 300. The amount of the tunable inductance offered by superconductor-semiconductor junction 300 depends on both the geometry of the junction and the stack of materials used to form the junction. As an example, the width (labeled as W in FIG. 3) of the junction can be set to meet the desired critical current (*Ic*)*.* The distance (D) between the two islands of superconductors is set by the superconducting coherence length. The superconducting coherence length in a nanowire within a hybrid superconductor-semiconductor device can be viewed as a distance that a zero-energy unpaired electron can penetrate into the proximitized nanowire.

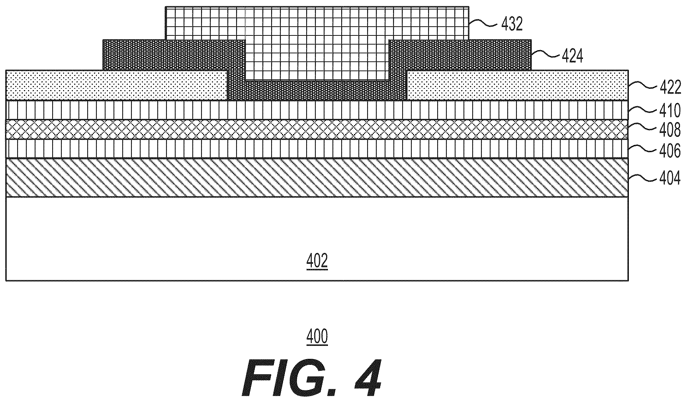

FIG. 4 shows a cross-section view of a hybrid superconductor-semiconductor device 400 including a superconductor-semiconductor junction for use with any of the active transfer switches of FIG. 2. FIG. 4 shows the results of several steps associated with the formation of the hybrid superconductor-semiconductor device 400. Each of the layers of hybrid superconductor-semiconductor device 400 may be formed using molecular-beam epitaxy (MBE). As an example, the MBE related process may be performed in an MBE system that allows atomic layer deposition of the appropriate materials in a vacuum. Starting with a substrate 402, a buffer layer 404 may be formed. Next, a quantum well layer 406 may be formed on top of buffer layer 404. Next, another buffer layer 408 may be formed on top of quantum well layer 406 to complete the formation of the heterostructure corresponding to one or more superconducting quantum wells. Buffer layer 408 may not be necessary to complete the formation of certain types of quantum wells. In this example, substrate 402 may be a gallium arsenide (GaAs) substrate. Instead of gallium arsenide, indium phosphide (InP) may also be used to form the substrate. Buffer layer 404 may be an indium gallium arsenide (InGaAs) layer. Quantum well layer 406 may be an indium arsenide (InAs) layer. Buffer layer 408 may be an indium aluminum arsenide (InAlAs) layer.

With continued reference to FIG. 4, as part of the next step, a metal layer 410 may be formed on top of buffer layer 408. In this example, metal layer 410 may be deposited using MBE. Metal layer 410 may be comprised of aluminum, niobium, or any other metal that may be superconducting at certain temperatures. As part of the next step, using semiconductor processing techniques, including patterning of photoresist, a portion of metal layer 410 may be selectively removed. Those portion(s) from where metal layer 410 has been removed may be used to form topologically active areas of the hybrid superconductor-semiconductor device 400. This step may be performed using a wet etch or a dry etch. The active areas may include quantum wells, e.g., GaAs quantum wells or InAs quantum wells. The quantum wells may be formed at a shallow depth (e.g., approximately within 10 nm of the surface).

Still referring to FIG. 4, as part of the next step a dielectric layer 422 may be formed. In this example, dielectric layer 422 is formed using atomic layer deposition. Dielectric layer 422 may be comprised of aluminum oxide (e.g., Al₂O₃). The formation of dielectric layer 422 may create a two-dimensional electron gas (2DEG) structure. The 2DEG structure may include trapped electrons with mobility in only two dimensions. As an example, the trapped electrons may not move in a vertical direction. Instead of the 2DEG structure, a two-dimensional hole gas (2DHG) structure may also be formed if materials such as graphene are used. The next step includes forming a gate 432 (e.g., a metal gate) for controlling certain aspects of the superconductor-semiconductor junction within hybrid superconductor-semiconductor device 400 during operation of the active transfer switch. In one example, gate 432 may be a niobium-titanium-nitride (NbTiN) stack. Although FIG. 4 shows a certain number of layers of hybrid superconductor-semiconductor device 400 arranged in a certain manner, there could be more, or fewer layers arranged differently. As an example, any of indium phosphide (InP), indium arsenide (InAs), indium antimonide (InSb), mercury cadmium telluride (HgCdTe), or any appropriate combination of materials selected from groups II, III, IV, V, and VI of the periodic table, or any ternary compounds of three different atoms of materials selected from groups II, III, IV, V, and VI of the periodic table may be used.

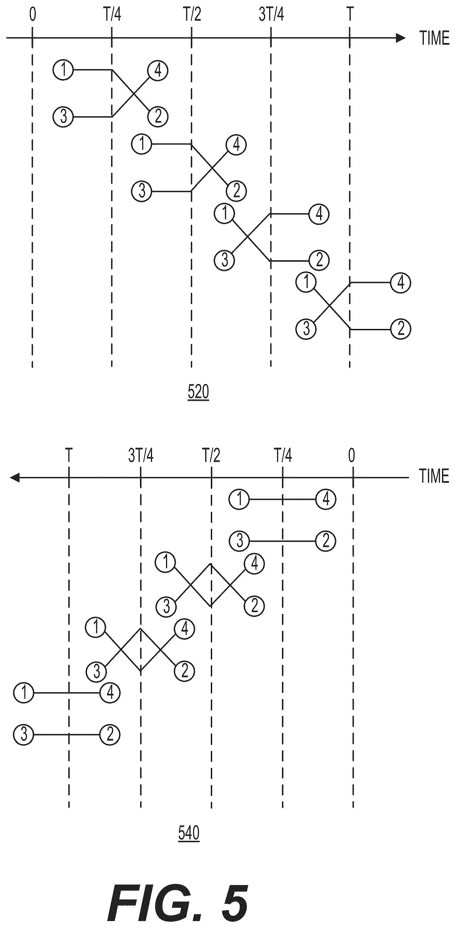

FIG. 5 is a diagram illustrating the operation of a circulator (e.g., circulator 160 of FIG. 1) in response to the gate voltage in accordance with one example. In terms of operation of the switches, as explained earlier, time-domain active switching is implemented by turning on and off switches to ensure that signals (e.g., microwave signals) always travel in one particular direction. As described earlier, a four-port circulator is constructed from two active transfer switches and a pair of delay lines. In one example, each of the switches is configured to operate in one of two configurations: a cross-configuration or a through-configuration. In the cross-configuration, signals cross over from a first side (e.g., the top side) of the switch to the other side (e.g., the bottom side) of the same switch. In the through-configuration, signals go through a first side (e.g., the top side) of the switch to the same side (e.g., the top side) of the same switch. As noted earlier, by toggling the switches between the two configurations as time progresses, one can achieve the desired operation of the circulator.

The delay for the signals as they progress through the delay lines is set to one quarter of the modulation period τ = T/4. The left and right active transfer switches (e.g., active transfer switch 220 and active transfer switch 240 of FIG. 2) are modulated with a period T and a relative phase of π/2. To illustrate the operation of the circulator, the modulation period is divided into quarter-period intervals. Timing diagram 520 depicts the way the switches will route a right-propagating signal (depending on its arrival time). Signals incident on port 1 are always routed to port 2, and signals incident on port 3 are routed to port 4. Note that these are not "snap-shots" of the switches' configurations, as the signal is delayed by a quarter-period of the modulation as it propagates through the network. Timing diagram 540 depicts the way the switches will route a left-propagating signal (depending on its arrival time). Signals incident on port 1 are always routed to port 2, and signals incident on port 3 are routed to port 4. To keep the device's orientation the same as with respect to timing diagram 520, time is shown flowing from right to left in this diagram. Although FIG. 5 shows the signals as having certain specific timing requirements, circulators with other timing requirements may also be implemented, as needed.

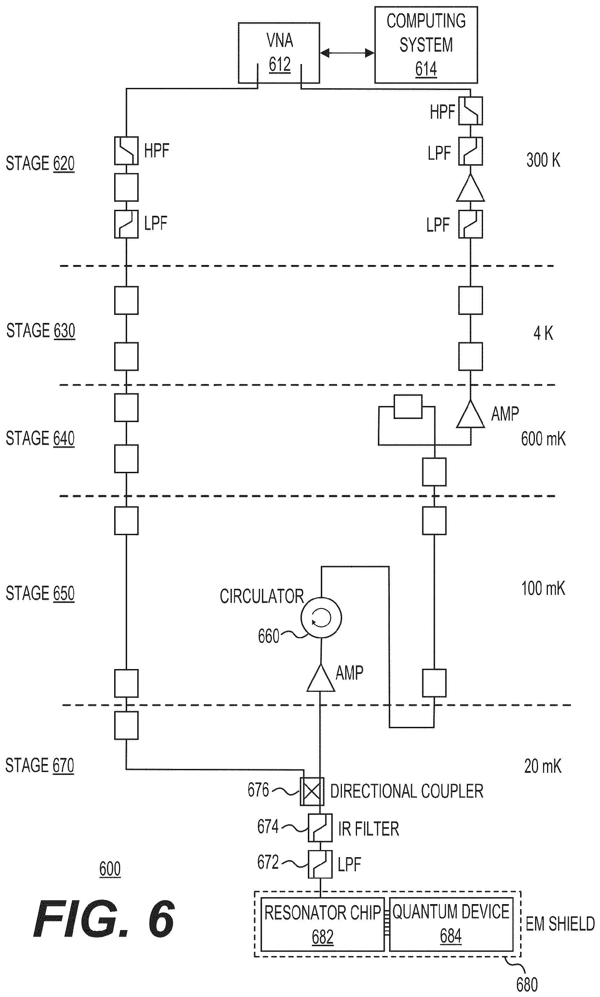

FIG. 6 is a block diagram of another example system 600 in which circulators described herein can be deployed. In this example, system 600 may include multiple stages, each of which may be configured to operate in different temperature environments. As an example, system 600 may include stages 620, 630, 640, 650, and 670. Stage 620 may include components configured to operate at the ambient temperature) (e.g., between 77 kelvin to 300 kelvin). Stage 630 may include components configured to operate at or below 77 kelvin and up to 4 kelvin. Stage 640 may include components configured to operate at or below 600 milli-Kelvin (mK). Stage 650 may include components configured to operate at or below 6100 milli-Kelvin (mK). Stage 670 may include components configured to operate at or below 20 milli-Kelvin (mK). One or more dilution refrigerators, not shown, may be used to maintain temperatures at or below 600 mK. In addition, some of the components may be located in a housing (not shown) that maintains a vacuum. These components and interconnects allow both the transmission of signals from a vector network analyzer (VNA) 612 to quantum system 680 and the reception of signals by VNA 612 transmitted from quantum system 680. The VNA 612 may further be coupled to a computing system 614, which may include instructions stored in a memory for executing methods to evaluate the performance of system 600, including circulator 660.

With continued reference to FIG. 6, stage 630 includes components configured to interconnect stage 620 with stage 640 in a manner that reduces thermal load and allows efficient connectivity between the components at room temperature and the components at 600 milli-Kelvin (mK). Stage 630 can include several cables comprising conductors implemented using niobium and copper or other similar materials. Stage 640 further includes an amplifier (AMP) and other components for coupling stage 630 with stage 650. Stage 650 includes a circulator 660 (similar to circulator 160 of FIG. 1), an amplifier (AMP), and other components.

Stage 670 includes a quantum system 680, which includes an electromagnetic (EM) shield, which encloses a resonator chip 682 and a quantum device 684. Quantum system 680 may be coupled to circulator 660 via a low pass filter (LPF) 672, an infrared (IR) filter 674, and a directional coupler 676. Resonator chip 682 may contain multiple inductive, capacitive, and resistive elements of suitable sizes to form bank(s) of resonators. At cryogenic temperatures, resonator circuits exhibit superconductivity and produce a resonator with high quality factors. This may provide an efficient low loss frequency multiplexing mechanism. Hybrid superconductor-semiconductor devices are examples of quantum devices that can be used as part of quantum systems, such as quantum system 680. Some of the quantum devices may comprise a 2-dimensional gas (2DEG), which may be manufactured by forming a series of layers of semiconductors on a substrate (e.g., using any of indium phosphide (InP), indium arsenide (InAs), indium antimonide (InSb), mercury cadmium telluride (HgCdTe), or any appropriate combination of materials selected from groups II, III, IV, V, or VI of the periodic table, or any ternary compounds of three different atoms of materials selected from groups II, III, IV, V, or VI of the periodic table). Other quantum devices may include nanowires or networks of nanowires. Additional quantum devices may include topological quantum devices with quantum dots, chains of quantum dots, and regions for inducing Majorana zero modes.

Advantageously, the use of voltage-tunable inductors comprising superconductor-semiconductor junctions allows one to evaluate various stacks and configurations of materials for use with both the quantum devices and the circulator. As an example, dispersive gate sensing may be used for readout of solid-state quantum bits, such as superconducting qubits, spin qubits, and topological qubits. In the context of topological qubits based on Majorana zero modes (MZMs), dispersive gate sensing can be used to measure an electron tunneling rate, which represents the state of the topological qubit. In many topological qubit systems, quantum dots (or chains of QDs) are used to couple or decouple MZMs by tuning such quantum dots (or chains of QDs). By obtaining both the real and the imaginary parts of the quantum capacitance using dispersive gate sensing, both the transition energy and the decoherence rate of the measured quantum system can be determined more accurately. Although FIG. 6 shows the system 600 as having a certain number of components and interconnects that are arranged in a certain manner, system 600 may include additional or fewer components and interconnects arranged differently. As an example, quantum system 680 may not include a resonator chip 682. Instead, the quantum device 684 may include components that provide similar functionality.

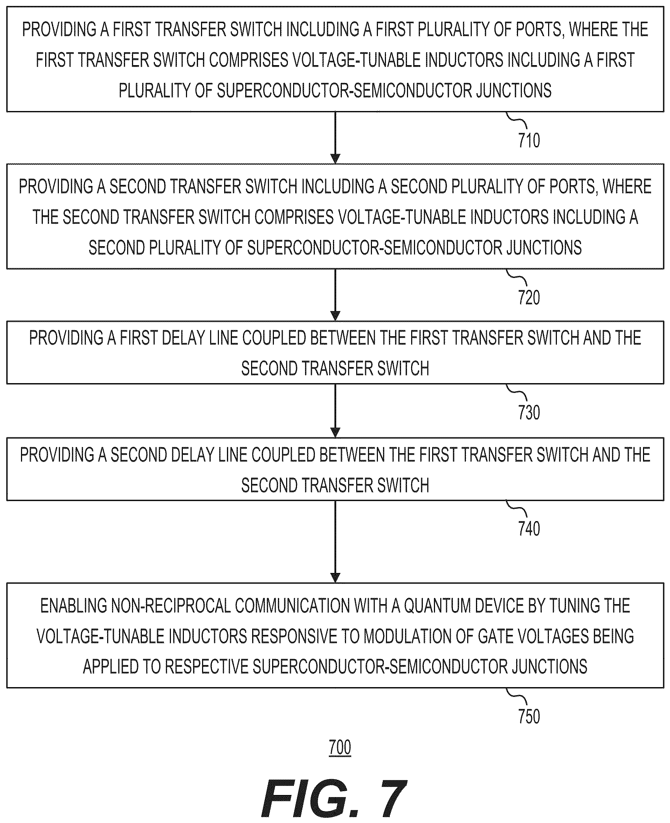

FIG. 7 is a flow chart 700 of a method for enabling readout of a quantum device in accordance with one example. The steps associated with this step may be performed as part of system 100 of FIG. 1 or system 600 of FIG. 6 using circulator 200 of FIG. 2. Step 710 comprises providing a first transfer switch including a first plurality of ports, where the first transfer switch comprises voltage-tunable inductors including a first plurality of superconductor-semiconductor junctions. Step 720 includes providing a second transfer switch including a second plurality of ports, where the second transfer switch comprises voltage-tunable inductors including a second plurality of superconductor-semiconductor junctions. Step 730 includes providing a first delay line coupled between the first transfer switch and the second transfer switch. Step 740 includes providing a second delay line coupled between the first transfer switch and the second transfer switch. These steps can be performed by providing circulator 200 of FIG. 2 with active transfer switches and delay lines. As shown earlier in FIG. 2, circulator 200 includes two active transfer switches 220 and 240, which are arranged as shown in FIG. 2. Circulator 200 further includes a pair of lines (delay lines 212 and 214) that are arranged as shown in FIG. 2.

With continued reference to FIG. 7, step 750 comprises enabling non-reciprocal communication with the quantum device by tuning the voltage-tunable inductors responsive to modulation of gate voltages being applied to respective superconductor-semiconductor junctions. As described earlier, gate voltages applied to the superconductor-semiconductor junctions can be used to tune the voltage-tunable inductors included within the circulator as part of the active transfer switches. Enabling non-reciprocal communication allows one to reduce noise ingress to the qubit while allowing quantum information egress to the classical readout system. Non-reciprocity also enables control and routing within a quantum processor.

In conclusion, the present disclosure relates to a circulator for enabling non-reciprocal communication with a quantum device. The circulator may comprise a first transfer switch including a first plurality of ports, where the first transfer switch comprises a first plurality of superconductor-semiconductor junctions. The circulator may further comprise a second transfer switch including a third plurality of ports, where the second transfer switch comprises a second plurality of superconductor-semiconductor junctions.

The circulator may further comprise a first delay line coupled between the first transfer switch and the second transfer switch. The circulator may further comprise a second delay line coupled between the first transfer switch and the second transfer switch. Modulation of gate voltages being applied to respective superconductor-semiconductor junctions allows the first transfer switch and the second transfer switch, in combination with the first delay line and the second delay line, to enable non-reciprocal communication with the quantum device.

Each of the first delay line and the second delay line may comprise a metamaterial transmission line. Each of the first plurality of superconductor-semiconductor junctions and the second plurality of superconductor-semiconductor junctions may include a gate terminal for the modulation of the gate voltages. Each of the first plurality of superconductor-semiconductor junctions and the second plurality of superconductor-semiconductor junctions may be configured based on both geometry and materials.

Each of the first plurality of superconductor-semiconductor junctions and the second plurality of superconductor-semiconductor junctions may be formed as part of a hybrid superconductor-semiconductor device including a 2-dimensional gas (2DEG). The quantum device may comprise at least one of: (1) quantum dots coupled with topological qubits or (2) a network of quantum dots.

In another example, the present disclosure relates to a method for enabling readout of a quantum device. The method may include providing a first transfer switch including a first plurality of ports, where the first transfer switch comprises voltage-tunable inductors including a first plurality of superconductor-semiconductor junctions. The method may further include providing a second transfer switch including a second plurality of ports, where the second transfer switch comprises voltage-tunable inductors including a second plurality of superconductor-semiconductor junctions.

The method may further include providing a first delay line coupled between the first transfer switch and the second transfer switch. The method may further include providing a second delay line coupled between the first transfer switch and the second transfer switch. The method may further include enabling non-reciprocal communication with the quantum device by tuning the voltage-tunable inductors responsive to modulation of the gate voltages being applied to respective superconductor-semiconductor junctions.

The method may further include performing dispersive gate sensing for performing readout of the quantum device. Each of the first delay line and the second delay line may comprise a metamaterial transmission line. Each of the first plurality of the superconductor-semiconductor junctions and the second plurality of the superconductor-semiconductor junctions may include a gate terminal for the modulation of the gate voltages.

The method may further include configuring each of the first plurality of the superconductor-semiconductor junctions and the second plurality of the superconductor-semiconductor junctions based on both geometry and materials. Each of the first plurality of the superconductor-semiconductor junctions and the second plurality of the superconductor-semiconductor junctions may be formed as part of a hybrid superconductor-semiconductor device including a 2-dimensional gas (2DEG). The quantum device may comprise at least one of: (1) quantum dots coupled with topological qubits or (2) a network of quantum dots.

In yet another example, the present disclosure relates to a qubit readout system coupled to a quantum device. The qubit readout system may comprise a readout path including a circulator for enabling non-reciprocal communication with the quantum device.

The circulator may comprise a first active transfer switch and a second active transfer switch. The circulator may further comprise a second plurality of delay lines coupled to a second active transfer switch. The circulator may further comprise a pair of delay lines coupled to both the first active transfer switch and the second active transfer switch, where each of the first active transfer switch and the second active transfer switch includes voltage-tunable inductors comprising superconductor-semiconductor junctions.

The first active transfer switch and the second active transfer may enable propagation of signals along the readout path in a particular direction at a given time. Each of the superconductor-semiconductor junctions may include a gate terminal for the selective application of gate voltages.

Each of the superconductor-semiconductor junctions may be configured based on both geometry and materials. Each of the superconductor-semiconductor junctions may be formed as part of a hybrid superconductor-semiconductor device including a 2-dimensional gas (2DEG). The quantum device may comprise at least one of: (1) quantum dots coupled with topological qubits or (2) a network of quantum dots.

It is to be understood that the systems, devices, methods, and components described herein are merely examples. Alternatively, or in addition, the functionality described herein can be performed, at least in part, by one or more hardware logic components. For example, and without limitation, illustrative types of hardware logic components that can be used include Field-Programmable Gate Arrays (FPGAs), Application-Specific Integrated Circuits (ASICs), Application-Specific Standard Products (ASSPs), System-on-a-Chip systems (SOCs), and Complex Programmable Logic Devices (CPLDs).

In an abstract, but still definite sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or inter-medial components. Likewise, any two components so associated can also be viewed as being "operably connected," or "coupled," to each other to achieve the desired functionality. Merely because a component, which may be an apparatus, a structure, a device, a system, or any other implementation of a functionality, is described herein as being coupled to another component does not mean that the components are necessarily separate components. As an example, a component A described as being coupled to another component B may be a sub-component of the component B, the component B may be a sub-component of the component A, or components A and B may be a combined sub-component of another component C.

The functionality associated with some examples described in this disclosure can also include instructions stored in a non-transitory media. The term "non-transitory media" as used herein refers to any media storing data and/or instructions that cause a machine to operate in a specific manner. Exemplary non-transitory media include non-volatile media and/or volatile media. Non-volatile media include, for example, a hard disk, a solid-state drive, a magnetic disk or tape, an optical disk or tape, a flash memory, an EPROM, NVRAM, PRAM, or other such media, or networked versions of such media. Volatile media include, for example, dynamic memory such as DRAM, SRAM, a cache, or other such media. Non-transitory media is distinct from, but can be used in conjunction with transmission media. Transmission media is used for transferring data and/or instruction to or from a machine. Exemplary transmission media include coaxial cables, fiber-optic cables, copper wires, and wireless media, such as radio waves.

Furthermore, those skilled in the art will recognize that boundaries between the functionality of the above described operations are merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the disclosure provides specific examples, various modifications and changes can be made without departing from the scope of the disclosure as set forth in the claims below. Accordingly, the specification and figures are to be regarded in an illustrative rather than a restrictive sense, and all such modifications are intended to be included within the scope of the present disclosure. Any benefits, advantages, or solutions to problems that are described herein with regard to a specific example are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A circulator (160, 200) for enabling non-reciprocal communication with a quantum device (184), the circulator (160, 200) comprising:
a first transfer switch (220) including a first plurality of ports (202, 204), wherein the first transfer switch (220) comprises a first plurality of superconductor-semiconductor junctions (300);
a second transfer switch (240) including a second plurality of ports (206, 208), wherein the second transfer switch (240) comprises a second plurality of superconductor-semiconductor junctions (300);
a first delay line (212) coupled between the first transfer switch (220) and the second transfer switch (240);
a second delay line (214) coupled between the first transfer switch (220) and the second transfer switch (240); and
wherein modulation of gate voltages being applied to respective superconductor-semiconductor junctions (300) allows the first transfer switch (220) and the second transfer switch (240), in combination with the first delay line (212) and the second delay line (214), to enable non-reciprocal communication with the quantum device (184).

2. The circulator of claim 1, wherein each of the first delay line and the second delay line comprises a metamaterial transmission line.

3. The circulator of claim 1 or claim 2, wherein each of the first plurality of superconductor-semiconductor junctions and the second plurality of superconductor-semiconductor junctions includes a gate terminal for the modulation of the gate voltages.

4. The circulator of any preceding claim, wherein each of the first plurality of superconductor-semiconductor junctions and the second plurality of superconductor-semiconductor junctions is configured based on both geometry and materials.

5. The circulator of any preceding claim, wherein each of the first plurality of superconductor-semiconductor junctions and the second plurality of superconductor-semiconductor junctions is formed as part of a hybrid superconductor-semiconductor device including a 2-dimensional gas.

6. The circulator of any preceding claim, wherein the quantum device comprises at least one of:
i) quantum dots coupled with topological qubits; and/or
ii) a network of quantum dots.

7. A qubit readout system (112, 114, 118, 160) coupled to a quantum device (184), the qubit readout system (112, 114, 118, 160) comprising: a readout path (172, 174 ... 112) including a circulator (160) for enabling non-reciprocal communication with the quantum device, wherein the circulator is as defined in any preceding claim.

8. The qubit readout system of claim 7, wherein the first transfer switch and the second transfer enable propagation of signals along the readout path in a particular direction at a given time.

9. The qubit readout system of claim 7 or claim 8, wherein the quantum device comprises at least one of:
i) quantum dots coupled with topological qubits; and/or
ii) a network of quantum dots.

10. A method for enabling readout of a quantum device, the method comprising:
providing a first transfer switch including a first plurality of ports, wherein the first transfer switch comprises voltage-tunable inductors including a first plurality of superconductor-semiconductor junctions;
providing a second transfer switch including a second plurality of ports, wherein the second transfer switch comprises voltage-tunable inductors including a second plurality of superconductor-semiconductor junctions;
providing a first delay line coupled between the first transfer switch and the second transfer switch;
providing a second delay line coupled between the first transfer switch and the second transfer switch; and
enabling non-reciprocal communication with the quantum device by tuning the voltage-tunable inductors responsive to modulation of gate voltages being applied to respective superconductor-semiconductor junctions.

11. The method of claim 10, further comprising performing dispersive gate sensing for performing readout of the quantum device.

12. The method of claim 10 or claim 11, wherein:
i) each of the first delay line and the second delay line comprises a metamaterial transmission line; and/or
ii) each of the first plurality of the superconductor-semiconductor junctions and the second plurality of the superconductor-semiconductor junctions includes a gate terminal for the modulation of the gate voltages.

13. The method of any of claims 10 to 12, further comprising configuring each of the first plurality of the superconductor-semiconductor junctions and the second plurality of the superconductor-semiconductor junctions based on both geometry and materials.

14. The method of any of claims 10 to 13, wherein each of the first plurality of the superconductor-semiconductor junctions and the second plurality of the superconductor-semiconductor junctions is formed as part of a hybrid superconductor-semiconductor device including a 2-dimensional gas.

15. The method of any of claims 10 to 14, wherein the quantum device comprises at least one of:
i) quantum dots coupled with topological qubits; and/or
ii) a network of quantum dots.
